(19) Europäisches Patentamt
European Patent Office
Office européen des brevets

(11) **EP 1 333 294 B1**

(12) **FASCICULE DE BREVET EUROPEEN**

(45) Date de publication et mention
de la délivrance du brevet:
**21.04.2010 Bulletin 2010/16**

(51) Int Cl.:
***H01M 10/44*** *(2006.01)*

(21) Numéro de dépôt: **03290136.5**

(22) Date de dépôt: **21.01.2003**

(54) **Procédé de contrôle de la décharge d'une batterie**

Entladungssteuerungsverfahren für eine Batterie

Discharge control method for a battery

(84) Etats contractants désignés:
**DE FR GB**

(30) Priorité: **31.01.2002 US 352507 P**

(43) Date de publication de la demande:
**06.08.2003 Bulletin 2003/32**

(73) Titulaire: **SAFT GROUPE SA**
**93170 Bagnolet (FR)**

(72) Inventeur: **Maloizel, Serge**
**16730 Trois Palis (FR)**

(74) Mandataire: **Hirsch & Associés**
**58, avenue Marceau**
**75008 Paris (FR)**

(56) Documents cités:
**US-A- 4 590 430      US-A- 6 072 300**

• **PATENT ABSTRACTS OF JAPAN vol. 2000, no. 21, 3 août 2001 (2001-08-03) & JP 2001 095169 A (DENSO CORP), 6 avril 2001 (2001-04-06)**

**Description**

L'invention concerne le domaine des batteries de générateurs électrochimiques, et plus particulièrement celui des dispositifs de contrôle de la fin de décharge de certaines batteries rechargeables constituées de modules montés en série, et comprenant des générateurs électrochimiques secondaires ou rechargeables (également appelés accumulateurs).

Il est notamment connu du document US-A-6 072 300 un appareil de diagnostique pour déterminer l'état d'une batterie pour déterminer si des modules ou la batterie elle-même est à changer. Ce dispositif de contrôle opère de la façon suivante. La tension aux bornes de chaque cellule est mesurée et on détermine si des cellules d'un module présente une déviation par rapport à l'écart type de la moyenne des tensions. Si la déviation est trop importante, l'appareil indique que la batterie doit être changée. Si un module présente une tension supérieure à cette déviation, l'appareil de diagnostic indique que ce module doit être changé.

Afin d'éviter que certaines batteries ne fassent l'objet de trop fortes décharges, susceptibles de les endommager par « inversion », on a proposé de les équiper d'un dispositif de contrôle de la fin de la décharge. Ce type de dispositif comporte généralement des moyens de contrôle chargés de mesurer, en fin de décharge, la tension aux bornes de chaque module de la batterie, puis de comparer ces tensions de fin de décharge à une tension seuil de module, dite tension d'arrêt, de manière à interrompre le fonctionnement de la batterie lorsque l'une au moins desdites tensions mesurées est inférieure à sa tension d'arrêt. Un tel dispositif est notamment décrit dans le document brevet SU-1686539.

Ce type de dispositif de contrôle convient assez bien aux batteries comprenant des modules munis d'un petit nombre de générateurs, ainsi qu'aux applications dans lesquelles les gammes d'intensité de courant et/ou de températures sont réduites. Lorsque la tension de la batterie devient importante, typiquement supérieure à environ 20 volts (V), ce type de dispositif de contrôle peut s'avérer gênant. En effet, lorsque l'un des générateurs d'un module est en situation de court-circuit, en raison notamment d'une défaillance ou d'une usure prématurée, la tension mesurée aux bornes du module défaillant devient inférieure à celles mesurées aux bornes des autres modules. Par conséquent, dès que le dispositif de contrôle s'aperçoit que la tension aux bornes du module défaillant est inférieure à la tension d'arrêt, il interrompt le fonctionnement de la batterie, alors qu'elle dispose encore d'une capacité utilisable non négligeable.

Par exemple, dans le cas d'une batterie comportant trois modules constitués chacun de dix générateurs présentant une tension moyenne de 1,2V, lorsque l'un des générateurs d'un module est en court-circuit, la tension moyenne de la batterie est égale à 34,8V au lieu de 36V, ce qui représente une perte de tension d'environ 3,3%. Or, si cette batterie est équipée d'un dispositif de contrôle configuré sur une tension d'arrêt de 10,5V, de manière à empêcher les inversions en fin de décharge jusqu'à une variation de capacité de la batterie d'environ 18% pour un courant de décharge faible et d'environ 90% pour un courant maximal, ledit dispositif va très rapidement détecter que le module fonctionnant avec neuf générateurs sur dix présente une tension inférieure à la tension d'arrêt, et par conséquent décider de l'interruption du fonctionnement de la batterie alors même qu'elle dispose d'une capacité utilisable comprise entre environ 18% et 90% et qu'elle n'a perdu que 3,3% de sa tension.

L'invention a donc pour but de remédier à cet inconvénient.

L'invention concerne en général un procédé selon l'une quelconque des revendications 1 à 10 et un dispositif selon l'une quelconque des revendications 11-19.

Elle propose à cet effet un dispositif dédié au contrôle de la fin de décharge d'une batterie équipée d'au moins un module comportant au moins deux générateurs électrochimiques secondaires montés en série, et comprenant des moyens de contrôle chargés de comparer, en fin de décharge de la batterie, la tension mesurée aux bornes de chaque module à une tension seuil de module, de manière à interrompre le fonctionnement de cette batterie lorsqu'au moins une tension mesurée est inférieure à la tension seuil de module.

Ce dispositif se caractérise par le fait que ses moyens de contrôle sont capables de déterminer, en fin de charge de la batterie, le nombre de générateurs en état de fonctionnement au sein de chaque module, puis la valeur de chaque tension seuil de module (ou tension d'arrêt), utilisée pour effectuer la comparaison, en fonction au moins du nombre de générateurs en état de fonctionnement.

En asservissant la valeur de la tension d'arrêt d'un module de batterie sur le nombre de générateurs capables de fonctionner en son sein, on peut ainsi continuer à utiliser toute la capacité disponible dans les générateurs qui demeurent en état de fonctionnement tout en empêchant qu'ils ne fassent l'objet d'une inversion en fin de décharge.

Selon une autre caractéristique de l'invention, les moyens de contrôle sont capables de déterminer la valeur de chaque tension seuil de module (ou tension d'arrêt), utilisée pour effectuer la comparaison, en fonction du nombre de générateurs en état de fonctionnement et d'une tension seuil de générateur, représentant la tension d'arrêt de la décharge d'un générateur, également appelée tension unitaire.

Dans un mode de réalisation préférentiel, le dispositif comprend des moyens de mesure électrique chargés de mesurer les tensions en fin de décharge et des tensions en fin de charge aux bornes de chaque module de la batterie, et ses moyens de contrôle sont agencés de manière à déterminer le nombre de générateurs en état de fonctionnement dans chacun des modules à partir de la tension mesurée en fin de charge au niveau de leurs bornes respectives, ainsi qu'éventuellement à partir d'une valeur nominale (théorique) de tension, correspondant à la tension, en fin de charge, aux bornes d'un générateur.

Le dispositif selon l'invention pourra comporter d'autres caractéristiques complémentaires qui pourront être prises séparément et/ou en combinaison, et en particulier

- des moyens de mesure électrique effectuant leurs mesures de tension en fin de décharge lorsque la batterie présente un courant sensiblement nul ;
- des moyens chargés de mesurer la température de chaque module, de sorte que les moyens de contrôle puissent déterminer le nombre de générateurs en état de fonctionnement dans chacun des modules à partir de la tension mesurée en fin de charge en leurs bornes et de la valeur nominale de tension associée au générateur, corrigée d'un premier facteur de correction fonction de la température mesurée du module ;
- des moyens chargés de mesurer le courant de décharge de la batterie, de sorte que les moyens de contrôle puissent déterminer chaque valeur de tension seuil de module (ou tension d'arrêt) en fonction du nombre de générateurs en état de fonctionnement au sein du module concerné et de la tension seuil de générateur de ce module (ou tension unitaire), corrigée d'un second facteur de correction fonction du courant de décharge et de la valeur de l'impédance du générateur. Dans ce cas, il est avantageux que les moyens de contrôle soient agencés de manière à corriger la valeur de l'impédance d'un générateur d'un module d'au moins un troisième facteur de correction fonction de la température du module ;
- des moyens de contrôle agencés de manière à corriger la tension seuil d'un module d'au moins un quatrième facteur de correction fonction de la température de ce module ;
- des moyens de contrôle agencés de manière à déterminer la valeur de l'impédance d'un générateur d'un module en fonction, d'une part, d'une variation de tension aux bornes de ce module, dans un intervalle de temps choisi, et d'autre part, d'une variation d'intensité de courant dans la batterie dans cet intervalle de temps ;
- une mémoire permettant de stocker les valeurs nominales et certains paramètres nominaux de générateurs, intervenant dans chacun des facteurs de correction, ainsi qu'éventuellement certaines au moins des valeurs déterminées ;
- une interface de communication couplée aux moyens de contrôle ;
- un interrupteur pour autoriser ou interdire la circulation de courant au sein de la batterie en fonction d'instructions reçues des moyens de contrôle ;
- des moyens de détection chargés de détecter la présence d'un système externe raccordé aux bornes de la batterie, comme par exemple un chargeur de batterie ou un appareil formant une charge.

L'invention concerne également un ensemble de batterie comportant au moins une batterie à modules de générateurs électrochimiques secondaires, montés en série, et un dispositif de contrôle du type de celui présenté ci-avant.

Par ailleurs, l'invention est particulièrement adaptée aux batteries et ensembles de batterie dont les générateurs électrochimiques sont choisis dans un groupe comprenant au moins les générateurs alcalins, et notamment les générateurs nickel / métal-hydrure (Ni/MH) et nickel / cadmium (Ni/Cd), et les générateurs au lithium, et en particulier les générateurs lithium / ion (Li/Ion).

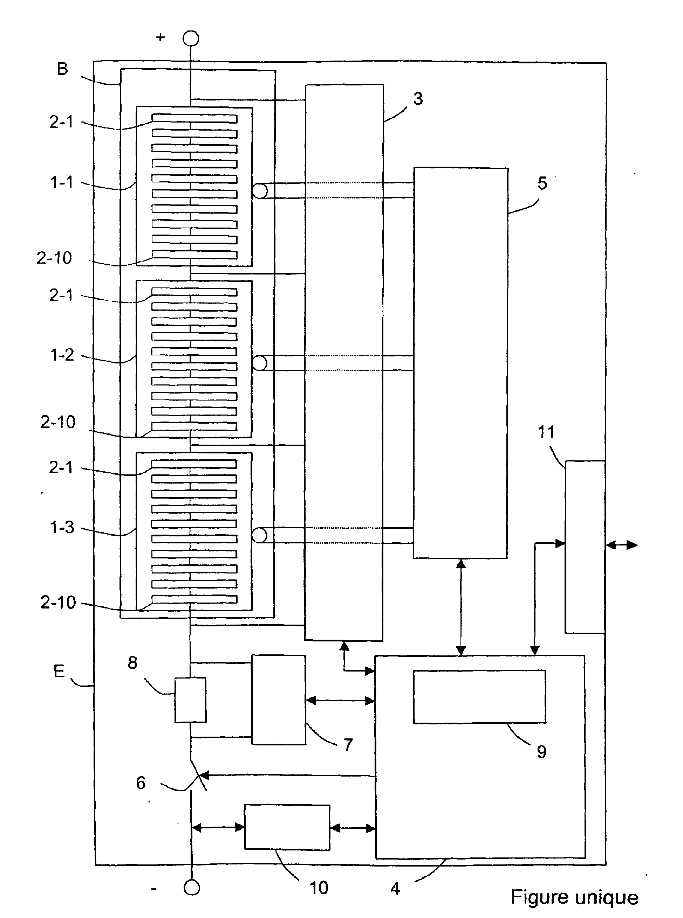

D'autres caractéristiques et avantages de l'invention apparaîtront à l'examen de la description détaillée ci-après, et de l'unique figure annexée qui illustre de façon schématique un exemple d'ensemble de batterie équipé d'un dispositif de contrôle selon l'invention. Cette figure pourra non seulement servir à compléter l'invention, mais aussi contribuer à sa définition, le cas échéant.

L'ensemble de batterie E illustré, à titre d'exemple, sur l'unique figure comporte tout d'abord une batterie B comprenant des modules 1-i (ici i = 1 à 3) montés en série et constitués de générateurs électrochimiques rechargeables (ou secondaires) 2-j (ici j = 1 à 10), également montés en série. Ces générateurs rechargeables 2-j sont préférentiellement de type alcalin, comme par exemple les générateurs nickel / métal-hydrure (Ni/MH) ou nickel / cadmium (Ni/Cd). Mais, il pourrait également s'agir de générateurs non aqueux comme par exemple les générateurs au lithium, et en particulier les générateurs lithium-ion (Li-ion). Dans ce qui suit, on considère que les générateurs rechargeables 2-j sont de type nickel / métal-hydrure (Ni/MH).

Bien entendu, l'invention n'est pas limitée au nombre de modules illustré. Elle concerne en effet toutes les batteries du type précité comportant au moins un module. Par ailleurs, l'invention n'est pas limitée aux modules constitués de dix générateurs. Elle concerne en effet tous les modules de batterie constitués d'au moins deux générateurs.

Afin de contrôler les décharges de la batterie B, l'ensemble de batterie E comporte un dispositif de contrôle comprenant tout d'abord un module de mesure électrique 3 chargé de mesurer, par exemple de façon continue ou de façon périodique, la tension électrique aux bornes de chaque module 1-i de la batterie B. Parmi ces mesures, on peut citer les mesures VFC-i effectuées en fin de charge de batterie et les mesures VFD-i effectuées en fin de décharge de batterie. Préférentiellement, les tensions VFD-i sont mesurées en fin de décharge à courant nul.

Ce dispositif de contrôle comporte en outre un module de contrôle 4 chargé de comparer, en fin de décharge de la batterie B, chaque tension VFD-i mesurée en fin de décharge par le module de mesure électrique 3 aux bornes de chaque module 1-i à une tension seuil de module TS1-i, préalablement déterminée, de manière à interrompre le fonctionnement de la batterie B lorsque l'une au moins des tensions mesurées VFD-i est inférieure à la valeur déterminée de la tension seuil de module correspondante TS1-i.

Selon l'invention, chaque tension seuil de module TS1-i est déterminée par le module de contrôle 4, en fin de charge de la batterie B. Pour ce faire, le module de contrôle 4 détermine tout d'abord le nombre Ni de générateurs 2-j en état de fonctionnement au sein de chaque module 1-i en fin de charge, puis la valeur de chaque tension seuil de module TS1-i en fonction au moins du nombre Ni de générateurs 2-j en état de fonctionnement. Par exemple, lorsqu'un module 1-i est constitué de 10 générateurs 2-1 à 2-10 présentant tous des tensions moyennes égales à environ 1,2V, la tension seuil de module TS1-i est égale à 10,5V.

Préférentiellement, le module de contrôle 4 détermine la valeur de chaque tension seuil de module TS1-i non seulement en fonction du nombre Ni de générateurs 2-j en état de fonctionnement mais également en fonction d'une tension seuil de générateur TS2. Cette tension seuil de générateur TS2 est une valeur nominale (théorique) correspondant à la tension d'arrêt de la décharge d'un générateur 2-j, également appelée tension unitaire. Dans l'exemple cité ci-dessus, la tension seuil de générateur (ou tension unitaire) TS2 est choisie sensiblement égale à 1,05 V.

Le nombre de générateurs 2-j en état de fonctionnement au sein de chaque module 1-i est déterminé en fin de charge par la relation (1) :

$$Ni = VFC\text{-}i \ / \ VG \qquad\qquad (1)$$

où VG est une valeur nominale (théorique) correspondant à la tension d'un générateur 2-j en fin de charge. Elle vaut 1,4V dans l'exemple cité ci-dessus.

Mais le module de contrôle 4 peut utiliser une relation plus complexe lorsque le dispositif de contrôle est, comme illustré sur l'unique figure, équipé d'un module de mesure de température 5 chargé de mesurer la température de chaque module 1-i. Dans ce cas, la relation (1) peut être par exemple remplacée par la relation (1') :

$$Ni = VFC\text{-}i \ / \ [VG + (K1 \times (Ti - 25°C))] \qquad\qquad (1')$$

où K1 x (Ti - 25°C) est un premier facteur de correction de la tension nominale VG en fonction de la température mesurée Ti du module 1-i et d'une constante choisie K1.

Bien entendu, le nombre de générateurs 2-j en état de fonctionnement au sein de chaque module 1-i pourrait être déterminé différemment. Ainsi, on pourrait équiper chaque générateur 2-j d'un dispositif de signalisation de fonctionnement.

La valeur de chaque tension seuil de module TS1-i (ou tension d'arrêt) est préférentiellement déterminée par le module de contrôle 4 à partir de la relation (2) :

$$TS1\text{-}i = TS2 \times Ni \qquad\qquad (2)$$

Lorsque le module de contrôle 4 a fini de déterminer la valeur de chaque tension seuil de module TS1-i, il peut procéder à la comparaison de chaque tension VFD-i, mesurée en fin de décharge aux bornes du module 1-i, à la valeur de la tension seuil de module TS1-i correspondante, de manière à interrompre le fonctionnement de la batterie B lorsque l'une au moins des tensions mesurées VFD-i est inférieure à la valeur de la tension seuil de module correspondante TS1-i. Afin de permettre au module de contrôle 4 de contrôler l'interruption de fonctionnement de la batterie, le dispositif de contrôle comprend un interrupteur (ou commutateur) 6 placé sur l'une des deux bornes de la batterie B (ici la borne « - ») et couplé audit module de contrôle 4.

Lorsque la batterie B doit délivrer une gamme importante de courants de décharge (I), il est avantageux que le dispositif de contrôle comporte un module de mesure de courant 7 comportant une résistance 8 (ou « shunt »), montée en série sur l'une des deux bornes de la batterie B (ici la borne « - »), et couplé au module de contrôle 4 pour l'alimenter en mesures I représentatives du courant de décharge de la batterie B. Dans ce cas, la relation (2) utilisée par le module de contrôle 4 pour déterminer la valeur de chaque tension seuil de module TS1-i peut être remplacée par la relation (2'), par exemple :

$$TS1\text{-}i = [TS2' - (R \times I)] \times Ni \qquad\qquad (2')$$

où R est l'impédance d'un générateur 2-j et TS2' est la tension seuil de générateur sans courant (ou tension unitaire sans courant).

Par ailleurs, lorsque la batterie B doit fonctionner dans une gamme importante de températures (Ti), il est avantageux que la relation (2') utilisée par le module de contrôle 4 pour déterminer la valeur de chaque tension seuil de module TS1-i soit remplacée par la relation (2"), par exemple :

$$TS1\text{-}i = [TS2'' + (K3 \times (Ti - 25°C)) - (R + (K2 \times (Ti - 25°C))) \times I] \times Ni \qquad (2'')$$

où K2 x (Ti - 25°C) est un troisième facteur de correction de l'impédance R en fonction de la température mesurée Ti du module 1-i et d'une constante choisie K2, K3 x (Ti - 25°C) est un quatrième facteur de correction de la tension seuil de générateur TS2 (ou tension unitaire) en fonction de la température mesurée Ti du module 1-i et d'une constante choisie K3, et TS2" est la tension seuil de générateur sans courant, à 25°C.

En outre, dans le but d'améliorer la précision de la détermination des tensions seuil de module TS1-i, le module de contrôle 4 peut être agencé de manière à utiliser une valeur d'impédance R variable, plutôt qu'une valeur prédéfinie. Par exemple, la valeur de l'impédance R d'un générateur d'un module peut être déterminée par le module de contrôle 4 grâce à la relation (3), par exemple :

$$R = (V2 - V1) / (I2 - I1) \qquad\qquad (3)$$

où V1 et V2 représentent les valeurs des tensions mesurées par le module de mesure électrique 3 aux bornes d'un module 1-i à des instants t1 et t2, et I1 et I2 représentent les intensités des courants mesurées par le module de mesure de courant 7 sur l'une des deux bornes de la batterie B (ici la borne « - ») auxdits instants t1 et t2.

Préférentiellement, le dispositif de contrôle 4 comporte une mémoire 9 (ici implantée dans le module de contrôle 4) dans laquelle sont stockés tous les paramètres et constantes (TS2, TS2', TS2", VG, K1, K2 et K3) intervenant dans le calcul des différentes variables (TS1-i, Ni et R) régies par les relations (1) à (3) précitées.

Cette mémoire 9 peut également servir à stocker les valeurs mesurées des tensions de fin de charge VFC-i, des tensions de fin de décharge VFD-i, des tensions V1 et V2, des courants de décharge I1 et I2, et des températures Ti, et les valeurs déterminées (ou calculées) des nombres Ni de générateurs 2-j en état de fonctionnement au sein de chaque module 1-i, et des tensions seuil de module TS1-i. Cela peut ainsi permettre au module de contrôle 4 d'effectuer des statistiques et/ou de générer des alarmes en cas de détection de problème.

Le dispositif de contrôle peut également comprendre un module de détection 10 placé sur l'une des bornes de la batterie B (ici la borne «- ») et chargé d'avertir le module de contrôle 4 lorsqu'un système externe, comme par exemple un chargeur de batterie ou un appareil formant une charge, est raccordé aux bornes « - » et « + » de la batterie B. Ce module de détection 10 permet notamment de refermer le commutateur 6 de manière à autoriser la charge de la batterie B lorsqu'elle est connectée au chargeur de batterie.

Enfin, le dispositif de contrôle peut également comporter une interface de communication 11 permettant l'échange de données avec un équipement de communication externe, adapté à cet effet, comme par exemple un micro-ordinateur portable ou un assistant numérique personnel (ou PDA pour Personal Digital Assistant) ou encore un boîtier dédié. Tout type d'interface peut être envisagé que ce soit par voie filaire ou par voie d'ondes, et notamment les connecteurs mâles ou femelles, les émetteurs/récepteurs radio (y compris de type Bluetooth ou IEEE 802.11 (ou WiFi)) ou infrarouge. Grâce à cette interface de communication 11, il est non seulement possible de mettre à la disposition d'un équipement externe les informations stockées dans la mémoire 9, mais également d'alimenter la mémoire 9 en paramètres et constantes utiles au module de contrôle 4. Mais cela peut également permettre de reconfigurer (ou reprogrammer) le module de contrôle 4 en fonction des besoins et du type de batterie qu'il doit équiper.

Le module de contrôle 4, et tout ou partie des modules de mesure électrique 3, de mesure de température 5, de mesure de courant 7 et de détection de présence 10, ainsi qu'éventuellement la mémoire 9, peuvent être réalisés sous la forme de circuits électroniques (ou « hardware »), de modules logiciels ou informatiques (ou « software »), ou d'une combinaison de circuits et de logiciels.

Dans la description qui précède, il a été donné des exemples de tensions mesurées et de tensions seuil adaptées à des batteries constituées de générateurs rechargeables de type nickel / métal-hydrure (Ni/MH). Bien entendu, lorsque les générateurs sont d'un autre type, comme c'est par exemple le cas des générateurs au lithium, il leur correspond d'autres valeurs de tensions.

L'invention ne se limite pas aux modes de réalisation de dispositifs de contrôle et d'ensembles de batterie décrits ci-avant, seulement à titre d'exemple, mais elle englobe toutes les variantes que pourra envisager l'homme de l'art dans le cadre des revendications ci-après.

Ainsi, le dispositif de contrôle selon l'invention peut comporter des moyens d'affichage, comme par exemple un écran de type LCD ou analogue, couplés éventuellement à un mini clavier, de manière à permettre la lecture des paramètres et informations stockés dans sa mémoire et/ou la saisie de nouveaux paramètres de fonctionnement.

## Revendications

1. Procédé de contrôle de la fin de décharge d'une batterie (B) comprenant au moins un module (1-i) comportant au moins deux générateurs électrochimiques secondaires (2-j) montés en série, le procédé comprenant les étapes consistant à :

   - déterminer, en fin de charge de ladite batterie (B), le nombre de générateurs (1-i) en état de fonctionnement dans ledit module (1-i),
   - déterminer une valeur de tension seuil de chaque module (TS1-i) en fonction dudit nombre de générateurs (2-j) en état de fonctionnement dans ledit module (1-i),
   - comparer, en fin de décharge de ladite batterie (B), une tension de fin de décharge (VFD-i) mesurée aux bornes de chaque module (1-i) à la valeur de tension seuil du modulé correspondant (TS1-i),
   - interrompre le fonctionnement de la batterie lorsqu'au moins une tension de fin de décharge mesurée (VFD-i) pour un module est inférieure à ladite valeur de tension seuil du module correspondant

2. Procédé de contrôle selon la revendications 1, dans lequel est déterminée en outre la tension seuil de chaque module (TS1-i) en fonction d'une tension seuil de générateur (TS2).

3. Procédé de contrôle selon l'une des revendications 1 et 2 comprenant en outre une étape consistant à mesurer des tensions de fin de charge (VFC-i) aux bornes de chacun desdits modules (1-i) et à déterminer le nombre de générateurs (2-j) en état de fonctionnement dans chacun desdits modules (1-i) à partir de ladite tension mesurée en fin de charge (VFC-i).

4. Procédé de contrôle selon la revendication 3 dans lequel le nombre de générateurs (2-j) en état de fonctionnement dans chacun desdits modules (1-i) est déterminé à partir de la tension mesurée en fin de charge (VFC-i) aux bornes de chacun desdits modules et d'une valeur nominale de tension (VG) correspondant à la tension aux bornes d'un générateur (2-j) en fin de charge

5. Procédé de contrôle selon l'une des revendications 1 à 4 dans lequel lesdites tensions de fin de décharge (VFD-i) sont mesurées aux bornes de chaque module lorsque ladite batterie (B) présente un courant sensiblement nul.

6. Procédé de contrôle selon la revendication 4, comprenant en outre une étape consistant à mesurer la température (Ti) de chaque module (1-i), ladite valeur nominale de tension (VG) étant corrigée d'un premier facteur de correction fonction de ladite température mesurée (Ti) dudit module (1-i).

7. Procédé de contrôle selon l'une des revendications 2 à 6, comprenant en outre une étape consistant à mesurer le courant de décharge (I) de ladite batterie (B) et à déterminer chaque valeur de tension seuil de module (TS1-l) en fonction dudit nombre de générateurs (2-j) en état de fonctionnement au sein dudit module (1-i) et de ladite tension seuil de générateur (TS2) dudit module (1-i), corrigée d'un second facteur de correction fonction dudit courant de décharge (I) et d'une valeur d'impédance (R) dudit générateur (2-j).

8. Procédé de contrôle selon les revendications 6 et 7, dans lequel ladite valeur de l'impédance (R) d'un générateur (2-j) d'un module (1-i) est corrigée par au moins un troisième facteur de correction fonction de ladite température (Ti) du module.

9. Procédé de contrôle selon les revendications 2 et 8, dans lequel ladite tension seuil de générateur (TS2) d'un module (1-i) est corrigée par au moins un quatrième facteur de correction fonction de ladite température (Ti) du module.

**10.** Procédé de contrôle selon l'une des revendications 7 à 9, dans lequel la valeur de l'impédance (R) d'un générateur (2-j) d'un module (1-i) est déterminée en fonction, d'une part, d'une variation de tension (V2 - V1) aux bornes dudit module dans un Intervalle de temps choisi (t2 - t1), et d'autre part, d'une variation d'intensité de courant (I2 - I1) dans ladite batterie (B) dans ledit intervalle de temps (t2-t1).

**11.** Dispositif de contrôle de la fin de décharge d'une batterie comprenant un module de contrôle (4) mettant en oeuvre le procédé selon l'une des revendications précédentes.

**12.** Dispositif selon la revendication 11, dans lequel le module de contrôle comporte une mémoire (9) propre à stocker lesdites valeurs nominales et certains paramètres nominaux de générateurs intervenant dans chacun desdits facteurs de correction.

**13.** Dispositif selon la revendication 12, dans lequel ladite mémoire (9) est propre à stocker certaines au moins des valeurs déterminées.

**14.** Dispositif selon l'une des revendications 11 à 13, comprenant une interface de communication (11) couplée auxdits moyens de contrôle (4).

**15.** Dispositif selon l'une des revendications 11 à 14, comprenant un interrupteur (6) agencé pour autoriser ou Interdire la circulation de courant au sein de ladite batterie (B) en fonction d'instructions reçues desdits moyens de contrôle (4).

**16.** Dispositif selon l'une des revendications 11 à 15, comprenant des moyens de détection (10) agencés pour détecter la présence d'un système externe raccordé aux bornes de ladite batterie (B).

**17.** Dispositif selon la revendication 16, dans lequel ledit système est choisi dans un groupe comprenant un chargeur de batterie et un appareil formant une charge.

**18.** Ensemble de batterie (E), comprenant au moins une batterie (B) et un dispositif de contrôle selon l'une des revendications 11 à 17.

**19.** Ensemble de batterie selon la revendication 18, dans lequel chaque générateur électrochimique secondaire (2-j) est choisi dans un groupe comprenant au moins les générateurs alcalins, et en particulier les générateurs nickel / métal-hydrure (Ni/MH) et nickel / cadmium (Ni/Cd), et les générateurs au lithium, et en particulier les générateurs lithium / ion (Li/Ion).


**Claims**

**1.** Method for controlling the end of discharge of a battery (B) comprising at least one module (1 - i) made up of at least two secondary electrochemical cells (2-j) connected in series, said method comprising:

   determining, at the end of charging of said battery (B), the number of cells (1 - i) in an operating state in said module (1 -i),
   determining a threshold voltage value for each module (TS1 - i) in operation of said number of cells (2 - j) in an operating state in said module (1 - i),
   comparing, at the end of discharge of said battery (B), an end of discharge voltage (VFD - i) measured at the terminals of each module (1 - i) at the threshold voltage value for the corresponding module (TS1 - i),
   interrupting the operation of the battery when at least one measured end of discharge voltage (VFD - i) for a module is less than said threshold voltage value for the corresponding module.

**2.** The controlling method according to claim 1, in which there is further determined the threshold voltage of each module (TS1 - i) as a function of a threshold voltage of the cell (TS2).

**3.** The controlling method according to one of claims 1 and 2 further comprising a step consisting in measuring the end of charging voltage (VFC - i) at the terminals of each one of said modules (1 - i) and determining the number of cells (2-j) in an operating state in each one of said modules (1 - i) on the basis of said end of charge voltage measured (VFC - i).

**4.** The controlling method according to claim 3, in which the number of cells (2-j) in an operating state in each one of said modules (1 - i) is determined from the end of charge voltage measured (VFC - i) at the terminals of each one of said modules and a nominal voltage value (VG) corresponding to the end of charge voltage at the cell terminals (2-j).

**5.** The controlling method according to one of claims 1 to 4 in which said end of discharge voltages (VFD - i) are measured at the terminals of each module when said battery (B) exhibits substantially zero current.

**6.** The controlling method according to claim 4, further comprising a step consisting in measuring the temperature (Ti) of each module (1 - i), said nominal voltage value (VG) being corrected by a first correction factor which is a function of said measured temperature (Ti) of said module (1 - i).

**7.** The controlling method according to one of claims 2 to 6, further comprising a step consisting in measuring the discharge current (I) of said battery (B) and in determining each threshold voltage value for the module (TS1 - i) as a function of said number of cells (2-j) in an operating state within said module (1 - i) and of said cell threshold voltage (TS 2) of said module (1 - i), corrected by a second correction factor which is a function of said discharge current (I) and an impedance value (R) for said cell (2-j).

**8.** The controlling method according to claims 6 and 7, in which said impedance value (R) of a cell (2-j) for a module (1 - i) is corrected by at least a third correction factor that is a function of said module temperature (Ti).

**9.** The controlling method according to claims 2 and 8, in which said cell threshold voltage (TS 2) for a module (1 - i) is corrected by at least a fourth correction factor that is a function of said module temperature (Ti).

**10.** The controlling method according to one of claims 7 to 9, in which the impedance (R) of a cell (2-j) of a module (1 - i) is determined as a function of, firstly, a variation in voltage (V2 - V1) at the terminals of said module in a selected time interval (t2 - t1) and, secondly, from a variation in current (I2-I1) in said battery (B) within said interval of time (t2 - t1).

**11.** Apparatus for controlling the end of discharge of a battery, comprising a control module (4) implementing the method according to one of the preceding claims.

**12.** The apparatus according to claim 11, in which the control module includes a memory (9) suitable for storing said nominal values and certain nominal parameters of cells involved in each of said correction factors.

**13.** The apparatus according to claim 12, in which said memory (9) is suitable for storing at least some of the determined values.

**14.** The apparatus according to one of claims 11 to 13, including a communications interface (11) coupled with said control means (4).

**15.** The apparatus according to one of claims 11 to 14, including a switch (6) arranged to allow or prevent current to flow through said battery (B) as a function of instructions received from said control means (4).

**16.** The apparatus according to one of claims 11 to 15, including detector means (10) arranged to detect the presence of an external system connected to the terminals of said battery (B).

**17.** The apparatus according to claim 16, in which said system is selected from a group comprising: a battery charger; and equipment constituting a load.

**18.** A battery assembly (E) comprising at least one battery (B) together with control apparatus according to one of claims 11 to 17.

**19.** A battery assembly according to claim 18, in which each secondary electrochemical cell (2-j) is selected from a group comprising: at least alkaline cells, and in particular nickel/metal hydride (Ni/MH) cells and nickel/cadmium (Ni/Cd) cells; and lithium cells, and in particular lithium/ion (Li/ion) cells.

**Patentansprüche**

1. Verfahren zur Kontrolle des Endes des Entladens einer Batterie (B), die mindestens ein Modul (1-i) aufweist, das mindestens zwei sekundäre elektrochemische Generatoren (2-j), die in Serie geschaltet sind, aufweist, wobei das Verfahren die Schritte aufweist, die aus Folgendem bestehen:

   - am Ende des Ladens der Batterie (B) Bestimmen der Anzahl Generatoren (1-i), die in dem Modul (1-i) in Betriebszustand sind,
   - Bestimmen eines Schwellenspannungswerts jedes Moduls (TS1-i) in Abhängigkeit von der Anzahl Generatoren (2-j), die in dem Modul (1-i) in Betriebszustand sind,
   - am Ende des Entladens der Batterie (B) Vergleichen einer Entladungsendspannung (VFD-i), die an den Klemmen jedes Moduls (1-i) gemessen wird, mit dem Schwellenspannungswert (TS1-i) des entsprechenden Moduls (TS1-i),
   - Unterbrechen des Betriebs der Batterie, wenn mindestens eine gemessene Entladungsendspannung (VFD-i) für ein Modul niedriger ist als der Schwellenspannungswert des entsprechenden Moduls.

2. Verfahren zur Kontrolle nach Anspruch 1, bei dem ferner die Schwellenspannung jedes Moduls (TS1-i) in Abhängigkeit von einer Generatorschwellenspannung (TS2) bestimmt wird.

3. Verfahren zur Kontrolle nach einem der Ansprüche 1 und 2, das ferner einen Schritt aufweist, der darin besteht, Ladeendspannungen (VFC-i) an den Klemmen jedes der Module (1-i) zu messen und die Anzahl Generatoren (2-j) in Betriebszustand in jedem der Module (1-i) ausgehend von der am Ende des Ladens gemessenen Spannung (VFC-i) zu bestimmen.

4. Verfahren zur Kontrolle nach Anspruch 3, bei dem die Anzahl Generatoren (2-j) in Betriebszustand in jedem der Module (1-i) ausgehend von der Spannung (VFC-i), die am Ende des Ladens an den Klemmen jedes der Module gemessen wird, und von einem Spannungsnennwert (VG), der der Spannung an den Klemmen eines Generators (2-j) am Ende des Ladens entspricht, bestimmt wird.

5. Verfahren zur Kontrolle nach einem der Ansprüche 1 bis 4, bei dem die Spannungen am Ende des Entladens (VFD-i) an den Klemmen jedes Moduls gemessen werden, wenn die Batterie (B) einen Strom im Wesentlichen gleich null aufweist.

6. Verfahren zur Kontrolle nach Anspruch 4, das ferner einen Schritt aufweist, der darin besteht, die Temperatur (Ti) jedes Moduls (1-i) zu messen, wobei der Spannungsnennwert (VG) um einen ersten Korrekturfaktor korrigiert wird, der von der gemessenen Temperatur (Ti) des Moduls (1-i) abhängt.

7. Verfahren zur Kontrolle nach einem der Ansprüche 2 bis 6, das ferner einen Schritt aufweist, der darin besteht, den Entladestrom (I) der Batterie (B) zu messen und jeden Modul-Schwellenspannungswert (TS1-i) in Abhängigkeit von der Anzahl Generatoren (2-j) in Betriebszustand innerhalb des Moduls (1-i) und der Generatorschwellenspannung (TS2) des Moduls (1-i), korrigiert mit einem zweiten Korrekturfaktor, der von dem Ladestrom (I) und einem Impedanzwert (R) des Generators (2-j) abhängt, zu bestimmen.

8. Verfahren zur Kontrolle nach einem der Ansprüche 6 und 7, bei dem der Impedanzwert (R) eines Generators (2-j) eines Moduls (1-i) mit mindestens einem dritten Korrekturfaktor, der von der Temperatur (Ti) des Moduls abhängt, korrigiert wird.

9. Verfahren zur Kontrolle gemäß den Ansprüchen 2 und 8, bei dem der Generatorspannungsschwellenwert (TS2) eines Moduls (1-i) mit mindestens einem vierten Korrekturfaktor, der von der Temperatur (Ti) des Moduls abhängt, korrigiert wird.

10. Verfahren zur Kontrolle nach einem der Ansprüche 7 bis 9, bei dem der Impedanzwert (R) eines Generators (2-j) eines Moduls (1-i) in Abhängigkeit einerseits von einer Spannungsvariation (V2 - V1) an den Klemmen des Moduls in einem ausgewählten Zeitintervall (t2-t1) und andererseits von einer Stromstärkenvariation (12 - 11) in der Batterie (B) innerhalb des Zeitintervalls (t2-t1) bestimmt wird.

11. Vorrichtung zur Kontrolle des Entladeendes einer Batterie, die ein Kontrollmodul (4) aufweist, das das Verfahren nach einem der vorhergehenden Ansprüche umsetzt.

**12.** Vorrichtung nach Anspruch 11, bei der das Kontrollmodul einen Speicher (9) aufweist, der die Nennwerte und bestimmte Nennparameter von Generatoren, die an jedem der Korrekturfaktoren beteiligt sind, speichern kann.

**13.** Vorrichtung nach Anspruch 12, bei der der Speicher (9) mindestens bestimmte Werte speichern kann.

**14.** Vorrichtung nach einem der Ansprüche 11 bis 13, die eine Kommunikationsschnittstelle (11) aufweist, die mit den Kontrollmitteln (4) gekoppelt ist.

**15.** Vorrichtung nach einem der Ansprüche 11 bis 14, die einen Schalter (6) aufweist, der eingerichtet ist, um das Zirkulieren von Strom innerhalb der Batterie (B) in Abhängigkeit von Anweisungen, die von den Kontrollmitteln (4) empfangen werden, zu gestatten oder zu verbieten.

**16.** Vorrichtung nach einem der Ansprüche 11 bis 15, die Erfassungsmittel (10) aufweist, die eingerichtet sind, um die Gegenwart eines externen Systems, das an den Klemmen der Batterie (B) angeschlossen ist, zu erfassen.

**17.** Vorrichtung nach Anspruch 16, bei der das System aus einer Gruppe ausgewählt wird, die ein Batterieladegerät und ein Gerät, das eine Last bildet, aufweist.

**18.** Batterieeinheit (E), die mindestens eine Batterie (B) und eine Kontrollvorrichtung nach einem der Ansprüche 11 bis 17 aufweist.

**19.** Batterieeinheit nach Anspruch 18, bei der jeder sekundäre elektrochemische Generator (2-j) aus einer Gruppe ausgewählt wird, die mindestens die alkalischen Generatoren und insbesondere die Nickel- /Metallhydrid- (Ni/MH) und Nickel-/Cadmium- (Ni/Cd)-Generatoren sowie die Generatoren mit Lithium und insbesondere die Lithium-/ Ionengeneratoren (Li/Ion) umfasst.

Figure unique

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6072300 A

- SU 1686539